Europäisches Patentamt

European Patent Office

Office européen des brevets

(19)

(11) Veröffentlichungsnummer: **0 501 598 A2**

## (12) EUROPÄISCHE PATENTANMELDUNG

(21) Anmeldenummer: **92250040.0**

(22) Anmeldetag: **21.02.92**

(51) Int. Cl.5: **H03M 1/82**

(30) Priorität: **26.02.91 DE 4106431**

(43) Veröffentlichungstag der Anmeldung:
**02.09.92 Patentblatt 92/36**

(84) Benannte Vertragsstaaten:
**AT BE CH ES FR GB IT LI NL SE**

(71) Anmelder: **SIEMENS AKTIENGESELLSCHAFT**
**Wittelsbacherplatz 2**
**W-8000 München 2(DE)**

(72) Erfinder: **Lesche, Wolfgang**
**Wildbergweg 13**
**W-1000 Berlin 37(DE)**

(54) **Digital-Analog-Umsetzverfahren und Vorrichtung zur Durchführung des Verfahrens.**

(57) Ein umzusetzender Digitalwert (DW) wird durch eine zeitliche Folge ($T_F$) von mehreren Perioden (P1...P16') mit jeweils einem durch das jeweilige Verhältnis einer Einschaltimpulsdauer ($t_p$) zu ihrer Periodendauer ($T_p$) bestimmten Tastverhältnis dargestellt. Zur Auflösungserhöhung enthalten die Perioden (P1... P16') einer Folge ($T_F$) Einschaltimpulsdauern ($t_{p1}...t_{p16}$), die sich um eine Systemtaktdauer ($t_o$) unterscheiden, wobei Perioden (P1,P2,P4,P6) mit gleichen Einschaltimpulsdauern annähernd gleichmäßig in der Folge verteilt werden. Die Tastverhältnisse einer Folge ($T_F$) werden zur Erzeugung eines Analogwertes (AW) ausgewertet.

FIG 2

Bei einem bekannten ("AD- und D/A-Wandler", Eckl/Pütgens/Walter, 1988, S. 79 ff.) Digital-Analog-Umsetzverfahren wird ein umzusetzender Digitalwert als Tastverhältnis einer Periode dargestellt. Unter Tastverhältnis ist das zeitliche Verhältnis zwischen der Dauer eines Einschaltimpulses (Einschaltimpulsdauer) zur gesamten Dauer der Periode (Periodendauer) zu verstehen, die den jeweiligen Einschaltimpuls enthält. Ein Schalter wird während der Einschaltimpulsdauer geschlossen und verbindet eine Filterstufe mit einer Referenzspannung. Auf diese Weise wird gemäß dem jeweiligen Tastverhältnis an dem Ausgang der Filterstufe ein dem umzusetzenden Digitalwert entsprechender Analogwert erzeugt. Zur Erzielung einer vernachlässigbar kleinen Restwelligkeit (Brummen) des Analogwertes bezogen auf seinen Mittelwert ist die Zeitkonstante des Filters verhältnismäßig groß zu wählen. Dadurch ist jedoch eine Steigerung der Auflösung bei dem bekannten Umsetzverfahren erheblich begrenzt bzw. nur unter Inkaufnahme einer noch weiter vergrößerten Zeitkonstante und damit entsprechend niedrigeren Grenzfrequenz des Systems erzielbar. Entspricht beispielsweise bei dem bekannten Verfahren die Periodendauer einer 16-fachen Systemtaktdauer, so sind Tastverhältnisse von 0/16, 1/16, 2/16, 3/16 ... 16/16 darstellbar. Um jedoch einen dazwischenliegenden Digitalwert, beispielsweise 2,5/16 darzustellen, ist bei dem bekannten Verfahren eine entsprechende Erhöhung der Periodendauer beispielsweise auf das 32-fache der Systemtaktdauer erforderlich, so daß dann ein Tastverhältnis von 5/32 unter Inkaufnahme der oben beschriebenen Absenkung der Grenzfrequenz realisierbar ist. Die dabei erforderliche Erhöhung der Zeitkonstanten wirkt sich auch auf die Einstellzeit des Systems, d. h. die Zeit bis zum Erreichen eines annähernd konstanten Mittelwertes der Ausgangs-Analoggröße, verlängernd aus.

Der Erfindung liegt daher die Aufgabe zugrunde, ein Digital-Analog-Umsetzverfahren zu schaffen, das sich durch eine erhöhte Auflösungsfähigkeit bei unveränderter Periodendauer auszeichnet und damit zur Darstellung von Digitalwerten in feiner Stufung ohne Verminderung der Grenzfrequenz geeignet ist.

Erfindungsgemäß wird diese Aufgabe gelöst durch ein Digital-Analog-Umsetzverfahren, bei dem ein umzusetzender Digitalwert durch eine zeitliche Folge von mehreren Perioden mit jeweils einem durch das jeweilige Verhältnis von einer Einschaltimpulsdauer zu Periodendauer bestimmten Tastverhältnis dargestellt wird, wobei die Einschaltimpulsdauern und die Periodendauer Vielfache einer Systemtaktdauer sind, bei dem eine Anzahl von Perioden der Folge eine Einschaltimpulsdauer aufweist, die sich von der jeweiligen Einschaltimpulsdauer der übrigen Perioden der Folge um eine Systemtaktdauer unterscheidet, wobei Perioden mit gleichen Einschaltimpulsdauern annähernd gleichmäßig in der Folge verteilt werden, und bei dem die Tastverhältnisse zur Erzeugung eines Analogwertes ausgewertet werden.

Bei dem erfindungsgmäßen Umsetzverfahren ist also ohne Verlängerung der Periodendauer ein feiner abgestufter Bereich von Digitalwerten umsetzbar, indem Perioden mit Einschaltimpulsdauern verwendet werden, die um eine Systemtaktdauer variieren. Zur Darstellung der Digitalwerte können entweder ausgewählte Einschaltimpulsdauern im Vergleich zu den übrigen Einschaltimpulsdauern um eine kleinste Einheit (Systemtaktdauer) verkürzt werden oder entsprechend ausgewählte Einschaltimpulsdauern um eine Systemtaktdauer verlängert werden. Beispielsweise wird ein Digitalwert von 2,5/16 als Gesamttastverhältnis von 16 Perioden dargestellt, indem bei einer ein 16-faches der Systemtaktdauer betragenden Periodendauer die Einschaltimpulsdauern alternierend das Zweifache bzw. Dreifache der Systemtaktdauer betragen. Durch die gleichmäßige Verteilung von Perioden mit gleichen Einschaltimpulsdauern wird der Einfluß der unterschiedlichen Tastverhältnisse auf den Ausgangswert (Brummen) in vorteilhafter Weise äußerst gering gehalten. Entsprechend wird ein Gesamttastverhältnis von 2,1 dadurch dargestellt, daß entweder ausgehend von einer Einschaltimpulsdauer von drei Systemtakten 15 Einschaltimpulsdauern jeweils um eine Systemtaktdauer vermindert werden oder ausgehend von einer Einschaltimpulsdauer von zwei Systemtaktdauern eine einzige Einschaltimpulsdauer auf drei Systemtaktdauern erhöht wird. Ein weiterer Vorteil des erfindungsgemäßen Verfahrens besteht darin, daß eine Erhöhung der Auflösung ohne Erhöhung der Einstellzeit erreicht wird.

Eine im Hinblick auf den Aufwand der Verfahrensdurchführung besonders günstige Ausgestaltung des erfindungsgemäßen Verfahrens besteht darin, daß der Digitalwert aus einem Hochwert und einem Niederwert zusammengesetzt wird, wobei die Einschaltimpulsdauern für jede Periode zunächst dem Hochwert entsprechend bemessen werden, daß ein Laufwert unter der Bedingung $O \leqq$ Laufwert < größtmöglicher Niederwert gewählt wird, daß nachfolgend für jede Periode der Folge die Summe von Niederwert und Laufwert neu als Laufwert verwendet wird und daß in dem Fall, daß der Laufwert größer oder gleich dem größtmöglichen Niederwert ist, für die jeweilige Periode die entsprechend dem Hochwert bemessene Einschaltimpulsdauer um eine Systemtaktdauer verlängert wird und die Differenz zwischen Laufwert und größtmöglichem Niederwert neu als Laufwert verwendet wird. Durch die verhältnismäßig geringe Anzahl der Verfahrensschritte zeichnet sich das erfindungsgemäße Verfahren durch einen äußerst geringen Zeitbedarf aus, so daß eine hohe Umsetzrate erzielbar ist.

Wie vorstehend bereits erläutert, läßt sich der Digitalwert auch darstellen, indem ausgehend von einer um eine Stufe (Systemtaktdauer) erhöhten Einschaltimpulsdauer die Einschaltimpulsdauern ausgewählter Perioden der Folge um eine Systemtaktdauer verkürzt werden. Dies laßt sich gemäß einer vorteilhaften Weiterbildung des erfindungsgemäßen Verfahrens besonders einfach dadurch realisieren, daß der Digitalwert aus einem Hochwert und einem Niederwert zusammengesetzt wird, wobei die Einschaltimpulsdauern jeder Periode zunächst dem um eine Systemtaktdauer erhöhten Hochwert entsprechend bemessen werden, daß ein Laufwert unter der Bedingung O≦ Laufwert < größtmöglicher Niederwert gewählt wird, daß nachfolgend für jede Periode der Folge die Summe von Niederwert und Laufwert neu als Laufwert verwendet wird, daß in dem Fall, daß der Laufwert kleiner als der größtmögliche Niederwert ist, der Hochwert um eine Systemtaktdauer erniedrigt wird und daß in dem Fall, daß der Laufwert größer oder gleich dem größtmöglichen Niederwert ist, die Differenz zwischen Laufwert und größtmöglichem Niederwert neu als Laufwert verwendet wird.

Eine hinsichtlich ihres Aufbaus besonders einfache Vorrichtung zur Durchführung des erfindungsgemäßen Verfahrens enthält einen ersten Addierer, dessen einer Eingang mit einem dem Niederwert entsprechenden Wert beaufschlagbar ist, dessen weiterer Eingang mit einem Ausgang eines Speichers verbunden ist, der seinerseits eingangsseitig mit einem Ausgang des ersten Addierers verbunden ist; einen zweiten Addierer, dessen einer Eingang mit einem dem Hochwert entsprechenden Wert beaufschlagbar ist und dessen weiterer Eingang mit einem Überlaufausgang des ersten Addierers verbunden ist; einen systemtaktgesteuerten Zähler, dessen Überlaufausgang mit einem Übernahmeeingang des ersten Speichers verbunden ist; einen Vergleicher, dessen einer Eingang mit dem Ausgang des Zählers und dessen weiterer Eingang mit dem Ausgang des zweiten Addierers verbunden ist und der ausgangsseitig einen Schalter steuert und eine Referenzgrößenquelle, die bei geschlossenem Schalter eine Filterstufe beaufschlagt, an der ausgangsseitig ein Analogwert abgreifbar ist. Die erfindungsgemäße Vorrichtung wird lediglich durch einen Systemtakt gesteuert und ist damit von weiteren Steuereinrichtungen, z. B. einer Zentralsteuerung, unabhängig und somit äußerst störunanfällig.

Um ausgehend von einem um eine Stufe erhöhten Hochwert mit einfachen Mitteln die Einschaltimpulsdauern dem umzusetzenden Digitalwert entsprechend zu verkürzen, enthält eine weitere Vorrichtung zur Durchführung des erfindungsgemäßen Verfahrens einen ersten Addierer, dessen einer Eingang mit einem dem Niederwert entsprechenden Wert beaufschlagbar ist, dessen weiterer Eingang mit einem Ausgang eines Speichers verbunden ist, der seinerseits eingangsseitig mit einem Ausgang des ersten Addierers verbunden ist; einen zweiten Addierer mit einem Eingang, der mit einem dem Hochwert entsprechenden Wert beaufschlagbar ist, mit einem weiteren Eingang, der mit einem der Systemtaktdauer entsprechenden Wert beaufschlagbar ist, und mit einem Subtraktionseingang, der über einen Inverter mit einem Überlaufeingang des ersten Addierers verbunden ist; einen systemtaktgesteuerten Zähler, dessen Überlaufausgang mit einem Übernahmeeingang des ersten Speichers verbunden ist; einen Vergleicher, dessen einer Eingang mit dem Ausgang des Zählers und dessen weiterer Eingang mit dem Ausgang des zweiten Addierers verbunden ist und der ausgangsseitig einen Schalter steuert und eine Referenzgrößenquelle, die bei geschlossenem Schalter eine Filterstufe beaufschlagt, an der ausgangsseitig ein Analogwert abgreifbar ist.

Die Erfindung wird nachfolgend anhand einer Zeichnung näher erläutert. Es zeigen

Figur 1 einen aus Hochwert und Niederwert zusammengesetzten Digitalwert,

Figur 2 den zeitlichen Verlauf einer Folge von Perioden mit nach dem erfindungsgemäßen Verfahren erzeugten und verteilten Einschaltimpulsen,

Figur 3 einen Ausschnitt aus Figur 2,

Figur 4 Verfahrensschritte zum Generieren von Einschaltimpulsen,

Figur 5 während der Verfahrensschritte gemäß Figur 4 auftretende Größen,

Figur 6 einen Teil einer Vorrichtung zur Durchführung des erfindungsgemäßen Verfahrens,

Figur 7 eine Vorrichtung zur Durchführung des erfindungsgemäßen Verfahrens,

Figur 8 Ausgangszustände von Elementen der Figur 7,

Figur 9 den zeitlichen Verlauf eines Analogwertes und

Figuren 10 und 11 Berechnungen zu Vergleichszwecken.

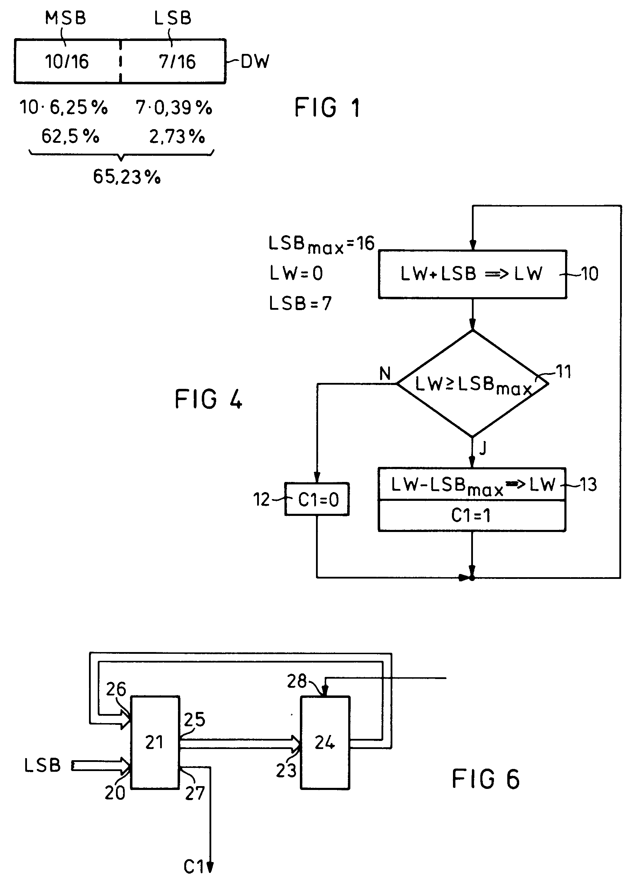

Figur 1 zeigt einen Digitalwert DW, der aus einem Hochwert MSB und einem Niederwert LSB gebildet wird; Hochwert MSB und Niederwert LSB sind jeweils ein vierstelliger Binärwert, so daß sie insgesamt je 16 verschiedene Werte annehmen können und auf die Basis 16 bezogen sind. Der Hochwert MSB ermöglicht (auf prozentualer Basis) jeweils eine Aufteilung eines Bereichs in 6,25% Schritten; diese Schritte werden durch den Niederwert LSB in Schritten von 0,39% interpoliert. Im vorliegenden Beispiel sind 10 zur Basis 16 für den Hochwert MSB und 7 zur Basis 16 für den Niederwert LSB gewählt, so daß sich insgesamt ein prozentualer Wert von 65,23 % für den Digitalwert DW ergibt.

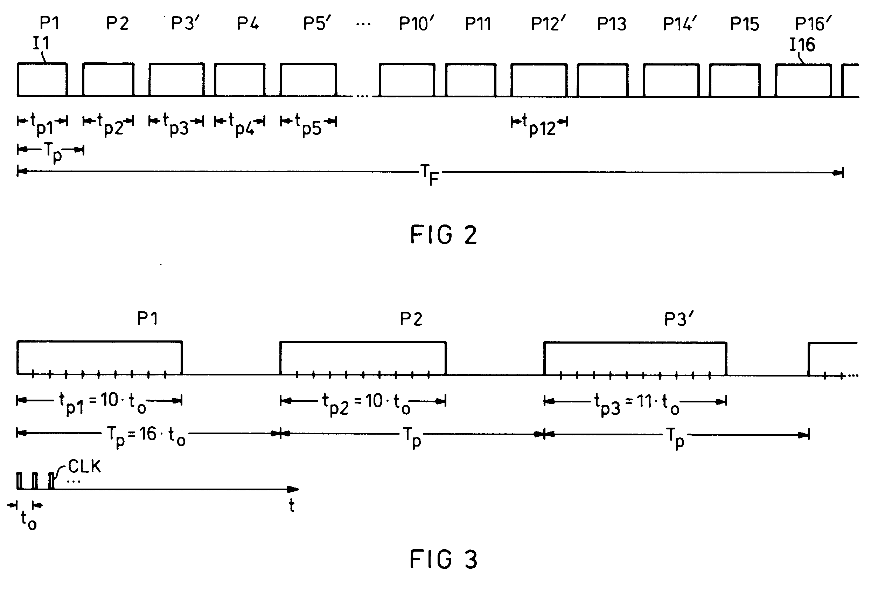

Figur 2 zeigt den aufgrund seiner 4-Bit-Wertigkeit in einer zeitlichen Folge $T_F$ von insgesamt 16 Perioden P1 bis P16' mit jeweils derselben Periodendauer $T_p$ dargestellten Hochwert MSB (Figur 1). Jede Periode P1 bis P16' kann einen Einschaltimpuls I1 bis I16 aufweisen. Die Einschaltimpulsdauer $t_p$ jedes Einschaltimpulses I1 bis I16 bestimmt in ihrem Verhältnis zur Periodendauer $T_p$ das Tastverhältnis jeder Periode P1 bis P16'. Nach einer Folge $T_F$ von 16 Perioden P1 bis P16' wird erneut eine gleiche Periodenfolge erzeugt, sofern der Digitalwert DW in der Zwischenzeit unverändert geblieben ist. Wie in Figur 2 andeutungsweise dargestellt, weisen verschiedene Perioden, beispielsweise die Perioden P3', P5' usw., im Vergleich zu den übrigen Perioden P1, P2, P4 usw. eine verlängerte Einschaltimpulsdauer $t_{p3}$, $t_{p5}$ usw. auf.

Figur 3 zeigt mit den Perioden P1, P2 und P3' einen Ausschnitt der Figur 2 zur Verdeutlichung der zeitlichen Zusammenhänge.

Zusätzlich ist ein Systemtakt CLK mit einer Systemtaktdauer $t_0$ gezeigt. Die Einschaltimpulsdauer $t_{p1}$ der Periode P1 beträgt das 10-fache der Systemtaktdauer $t_0$, und die Periodendauer $T_p$ beträgt jeweils für alle Perioden das 16-fache der Systemtaktdauer $t_0$. Die Einschaltimpulsdauer $t_{p3}$ der Periode P3' beträgt dagegen das 11-fache der Systemtaktdauer $t_0$. Die Perioden P1 bzw. P3' weisen damit ein Tastverhältnis von 10/16 bzw. 11/16 auf.

Sämtliche in der Figur 2 gestrichen bezeichneten Perioden P3', P5' usw. weisen ein Tastverhältnis von 11/16 auf und sind somit im Vergleich zu den übrigen Perioden P1, P2 usw., die ein Tastverhältnis von 10/16 aufweisen, um eine Systemtaktdauer $t_0$ (Figur 3) verlängert. Die Perioden P3', P5' usw. sind bezüglich ihres zeitlichen Auftretens in der Folge der Perioden P1 bis P16' annähernd gleichmäßig verteilt.

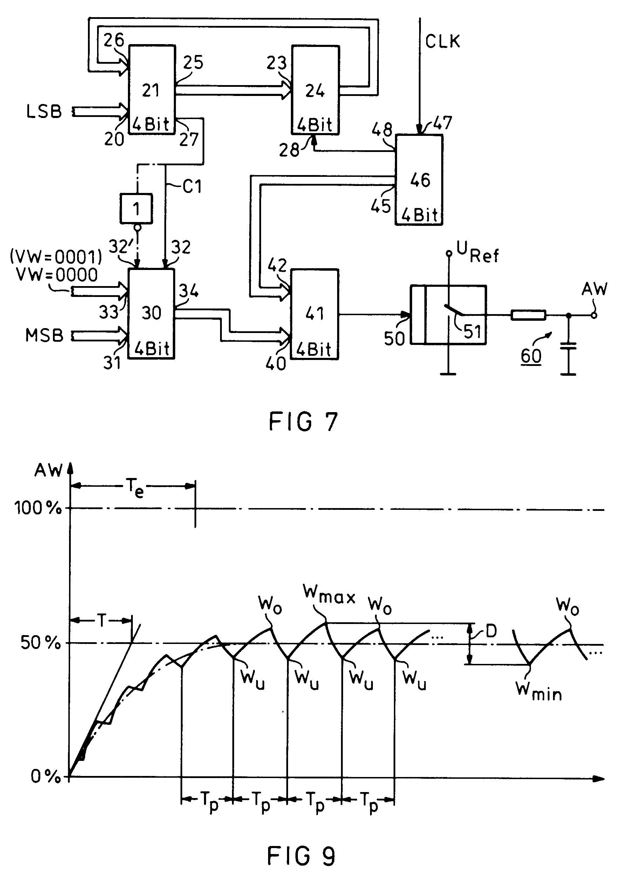

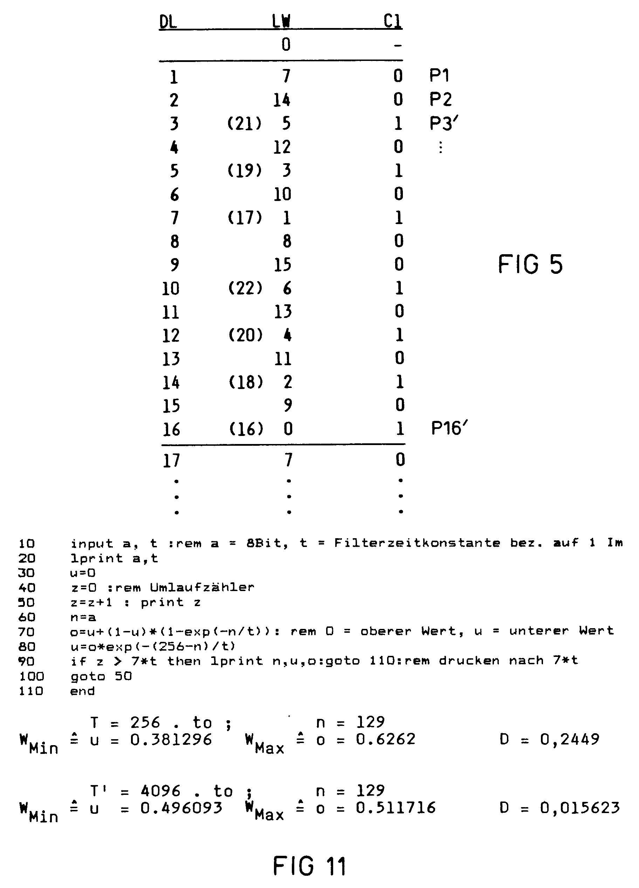

Ein Verfahren zur Generierung und gleichmäßigen Verteilung von Perioden mit verlängerter (bzw. verkürzter) Dauer ihrer Einschaltimpulse wird anhand der Figuren 4 und 5 näher erläutert. Figur 4 zeigt schematisch das Verfahren zur Bestimmung der Periodendauer und -position. $LSB_{max}$ bezeichnet einen größtmöglichen Niederwert. Wegen der für den Niederwert LSB (Figur 1) angenommenen Wertigkeit von 4 Bit ergibt sich ein größtmöglicher Wert $LSB_{max}$ für den Niederwert LSB von 16. Vorab wird ein Laufwert LW unter der Bedingung $O \leq LW < LSB_{max}$ gewählt; im vorliegenden Beispiel ist LW = O. Für den gewählten Niederwert gilt LSB = 7 (vgl. Figur 1). Für jede Periode wird in einem ersten Schritt 10 die Summe des Laufwertes LW und des Niederwertes LSB gebildet und diese als neuer Laufwert LW verwendet.

Für das gewählte Beispiel zeigt Figur 5 den jeweiligen Laufwert LW in bezug auf die jeweilige Periode P1... P16' bzw. den entsprechenden Verfahrensdurchlauf DL. In einem zweiten Schritt 11 (Figur 4) wird geprüft, ob der Laufwert LW größer oder gleich dem größtmöglichen Niederwert $LSB_{max}$ ist. Ist dies nicht der Fall, wird eine Variable C1 auf den Wert O gesetzt (Schritt 12) und der nächste Verfahrensdurchlauf DL beginnend mit Schritt 10 für die nächster Periode durchgeführt. Die zeitliche Abfolge und die Bedeutung der Variablen C1 wird nachfolgend noch detailliert erläutert. Ist der Laufwert LW größer oder gleich dem größtmöglichen Niederwert $LSB_{max}$, so wird einerseits von dem Laufwert LW der größtmögliche Niederwert $LSB_{max}$ subtrahiert und das Ergebnis als neuer Laufwert LW verwendet und andererseits erhält die Variable C1 den Wert 1 (Schritt 13); anschließend wird für die nächste Periode mit Schritt 10 begonnen. Wie beispielsweise der dritte Verfahrensdurchlauf DL der Figur 5 zeigt, ergibt die weitere Erhöhung des Laufwertes LW im Verfahrensschritt 10 (Figur 4) eine Erhöhung auf den Wert 21, der über dem größtmöglichen Niederwert $LSB_{max}$ liegt, so daß eine Subtraktion mit dem größtmöglichen Niederwert $LSB_{max}$ erfolgt, so daß der Laufwert LW auf den Wert 5 und die Variable C1 auf den Wert 1 gesetzt wird. Nach 16 Verfahrensdurchläufen DL wiederholen sich bei unverändertem Digitalwert DW (Fig. 1) die Werte für den Laufwert LW bzw. die Variable C1 erneut.

Figur 6 zeigt einen Teil einer Vorrichtung zur Durchführung des erfindungsgemäßen Verfahrens, in dem die Ermittlung der Variablen C1 (Figur 5) erfolgt. Ein erster Eingang 20 eines Addierers 21 wird mit einem dem Niederwert LSB entsprechenden Wert beaufschlagt. Ein Eingang 23 eines Speichers 24 ist mit einem Ausgang 25 des Addierers 21 verbunden. Ausgangsseitig ist der Speicher 24 auf einen weiteren Eingang 26 des Addierers 21 geführt. Der Addierer 21 ist für die Addition zweier 4-Bit-Werte ausgelegt, so daß jeweils am Überlaufausgang 27 ein Wert 1 für die Variable C1 (vgl. Figur 5) ausgegeben wird, wenn das Additionsergebnis den Wert 16 übersteigt. Der am Ausgang 23 anliegende Wert wird in den Speicher 24 übernommen, wenn ein Übernahmeeingang 28 mit einem Übernahmesignal beaufschlagt wird. Addierer 21 und Speicher 24 wirken in der Weise zusammen, daß je nach anliegendem Niederwert LSB und Steuerung des Speichers 24 am Überlaufausgang 27 der entsprechende Wert für die Variable C1 gemäß Figur 5 erzeugt wird.

Figur 7 zeigt eine Vorrichtung zur Durchführung des erfindungsgemäßen Verfahrens, wobei der Teil gemäß Figur 6 Bestandteil der Vorrichtung ist und mit den gleichen Bezugzeichen wie in Figur 6 versehen ist. Die Vorrichtung der Figur 7 weist einen weiteren Addierer 30 mit Eingängen 31, 32 und 33 auf. Auf den Eingang 31 ist ein dem Hochwert MSB des Digitalwertes DW (Figur 1) entsprechender Wert geführt, während der Überlaufausgang 27 des Addierers 21 auf den Eingang 32 geführt ist. Der Eingang 33 ist mit einem 4-Bit-Vorgabewert VW beaufschlagbar, der im vorliegenden Beispiel zunächst zu O gewählt ist.

Ein Ausgang 34 des weiteren Addierers 30 ist auf einen Eingang 40 eines Vergleichers 41 geführt, dessen weiterer Eingang 42 mit einem Ausgang 45 eines 4-Bit-Zählers 46 verbunden ist. Ein Takteingang 47 des Zählers 46 ist mit dem Systemtakt CLK beaufschlagt und ein Überlaufausgang 48 ist auf den Übernahmeeingang 28 des Speichers 24 geführt. Ausgangsseitig ist der Vergleicher 41 auf einen Steuereingang 50 eines Schalters 51 geführt, der in geschlossenem Zustand eine Referenzgrößenquelle in Form einer Referenzspannung $U_{Ref}$ mit einer Filterstufe 60 verbindet. An der Filterstufe 60 wird ausgangsseitig ein dem umzusetzenden Digitalwert DW (Figur 1) entsprechenden Analogwert AW abgegriffen.

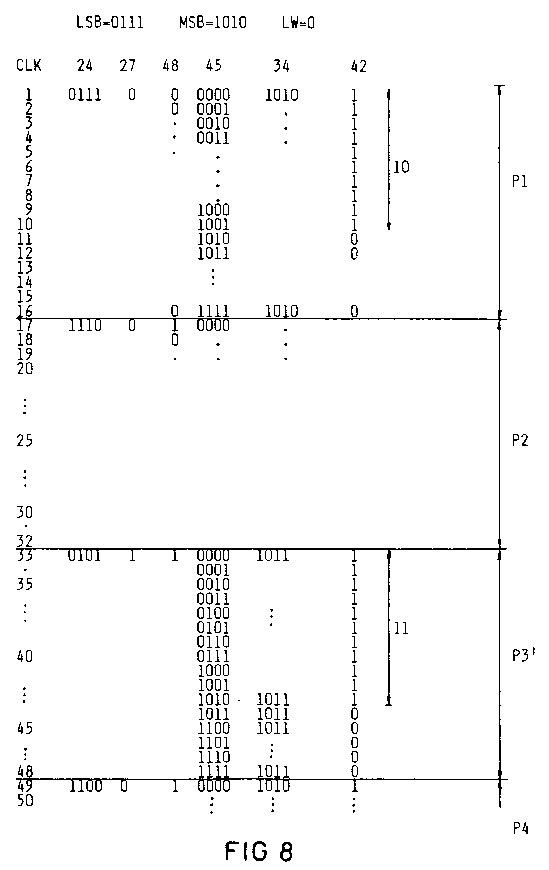

Die Wirkungsweise der Vorrichtung gemäß Figur 7 wird unter Zuhilfenahme der Figur 8 erläutert, wobei Figur 8 in Abhängigkeit von dem Systemtakt CLK die Ausgangszustände des Speichers 24, des Zählers 46, des Vergleichers 41, des Addierers 30 (Ausgang 34), des Überlaufausgangs 27 sowie des Überlaufausgangs 48 zeigt.

Gemäß Figur 8 weist der Zähler-Ausgang 45 bei Verfahrensbeginn mit dem ersten Systemtakt CLK den Stand 0000 auf und am Ausgang des Addierers 21 tritt der Wert 0111 (Dezimalwert 7 / vgl.

Laufwert beim ersten Verfahrensdurchlauf DL gemäß Figur 5) auf. Da der Laufwert LW (Speicherinhalt des Speichers 24) bei Verfahrensbeginn auf LW = O gesetzt ist, tritt auch während der folgenden 15 Systemtakte CLK am Ausgang des Addierers 21 der Wert 0111 - d. h. der am Eingang 21 anliegende Niederwert LSB - unverändert auf, während mit jedem Systemtakt CLK der Zähler 46 um jeweils eine Stufe hochzählt. Aufgrund des am Eingang 31 anliegenden Hochwertes MSB 1010 (Dezimalzahl 10 / vgl. Figur 1) stellt sich das Ausgangssignal des Vergleichers 42 für die ersten zehn Systemtakte CLK auf den Wert 1 und geht beim elften Systemtakt auf den Wert O zurück, weil der Zählerstand den Wert des Ausgangs 34 erreicht bzw. nachfolgend überschreitet.

Mit dem 16. Systemtakt ist die Bearbeitung der Periode P1 abgeschlossen. Mit dem 17. Systemtakt CLK erreicht der Zähler 46 wieder den Stand 0000 und gibt auf seinem Überlaufausgang 48 ein Überlaufsignal ab, durch das der bisherige Ausgangswert des Addierers 21 in den Speicher 24 übernommen wird. Durch die Rückkopplung des Speichers 24 auf den weiteren Eingang 26 stellt sich das Ausgangssignal des Addierers 21 nunmehr auf den Wert 1110 (Dezimalwert 14 vgl. Figur 5). Wie vorstehend beschrieben, wird während der restlichen folgenden 15 Systemtakte CLK der Periode P2 der Zähler 46 hochgezählt, so daß sich das Ausgangssignal des Vergleichers 41 erneut 10 mal auf den Wert 1 stellt. Mit dem 33. Systemtakt CLK wird der Zähler 46 erneut zurückgesetzt und bewirkt durch das auf seinem Überlaufausgang 48 ausgegebene Signal die Übernahme des bisherigen Ausgangs des Addierers 21 in den Speicher 24, wodurch der Ausgangswert des Addierers 21 den Wert 0101 (Dezimalwert 5 vgl. Figur 5) annimmt und gleichzeitig auf seinem Überlaufausgang 27 ein Signal abgibt, das auf den Eingang 31 des weiteren Addierers 30 geführt ist. Gleichzeitig ist damit eine Subtraktion des größtmöglichen Niederwertes $LSB_{max}$ vom Laufwert LW realisiert, da am Ausgang 25 des Addierers 24 nun der Wert 5 ($\hat{=}$ A (LW = 21) ($LSB_{max}$ = 16)) als neuer Laufwert LW anliegt. Der Vergleicher 41 wird daher im Unterschied zu den vorangehenden Perioden P1 und P2 numehr mit dem Wert 1011 (Dezimalzahl 11) beaufschlagt. Dementsprechend wird während der Periode P3' bei den ersten 11 Takten dieser Periode ein Ausgangssignal des Vergleichers 41 mit dem Wert 1 erzeugt. Wie in der Figur 8 schließlich angedeutet ist, bewirkt in der nachfolgenden Periode P4 das Überlaufsignal des Zählers 46 das Einschreiben des bisherigen Ausgangswertes des Addierers 21 in den Speicher 24, so daß nunmehr der Wert 1100 (Dezimalwert 12, vgl. Figur 5) ausgangsseitig am Addierer 21 anliegt und kein Überlaufsignal zum weiteren Addierer 30 gelangt. Daher gibt der Vergleicher 41 während der Periode P4 wie im Zusammenhang mit den Perioden P1 bzw. P2 beschrieben lediglich 10 mal ein Ausgangssignal mit dem Wert 1 ab.

Dadurch wird in schaltungstechnisch einfacher Weise und äußerst zuverlässig eine Modulation der in der Figur 2 gezeigten Einschaltimpulsdauern generiert, wobei insgesamt 7 Perioden P3',P5', P7',P10',P12',P14' und P16' ein Tastverhältnis 11/16 und 9 Perioden P1,P2,P4,P6,P8,P9,P11,P13 und P15 ein Tastverhältnis 10/16 aufweisen, wobei automatisch eine annähernd gleichmäßige Verteilung der Perioden mit einem verlängerten Einschaltimpuls in der Folge von Perioden erfolgt.

Durch geringe Abänderung der in der Figur 7 gezeigten Schaltung bzw. der Beaufschlagung des Eingangs 33 des Addierers 30 läßt sich das erfindungsgemäße Verfahren auch in der Weise durchführen, daß ausgehend von einem erhöhten Hochwert MSB eine entsprechende Verkürzung der jeweiligen Einschaltimpulsdauern um eine System-

taktdauer $t_o$ erfolgt. In diesem Fall wird der Eingang 33 mit einem Vorgabewert VW = 0001 beaufschlagt und der Überlaufausgang 27 des Addierers 21 invertiert und einem Subtraktionseingang 32 des Addierers 30 zugeführt (strichpunktiert dargestellt). Auf diese Weise wird jeweils beim Auftreten des Wertes O für die Variable C1 (vgl. Figur 5) der Wert 1 von der Summe der an den Eingängen 31 (MSB) bzw. 33 (Wert 0001) subtrahiert. Im vorliegenden Beispiel würde also der Hochwert MSB grundsätzlich zur Bildung von Perioden P1 bis P16' mit Einschaltimpulsen von 11-facher Systemtaktdauer $t_o$ führen, wobei jeweils beim 1.,2.,4.,6. usw. Systemtakt CLK eine Verminderung Einschaltimpulsdauer der entsprechenden Perioden P1,P2,P4,P6 usw. auf die 10-fache Dauer der Systemtaktdauer $t_o$ erfolgt. Im Endergebnis wird damit eine Folge von 16 Perioden in der gleichen Konfiguration wie vorstehend ausführlich im Zusammenhang mit der Figur 7 beschrieben erzeugt.

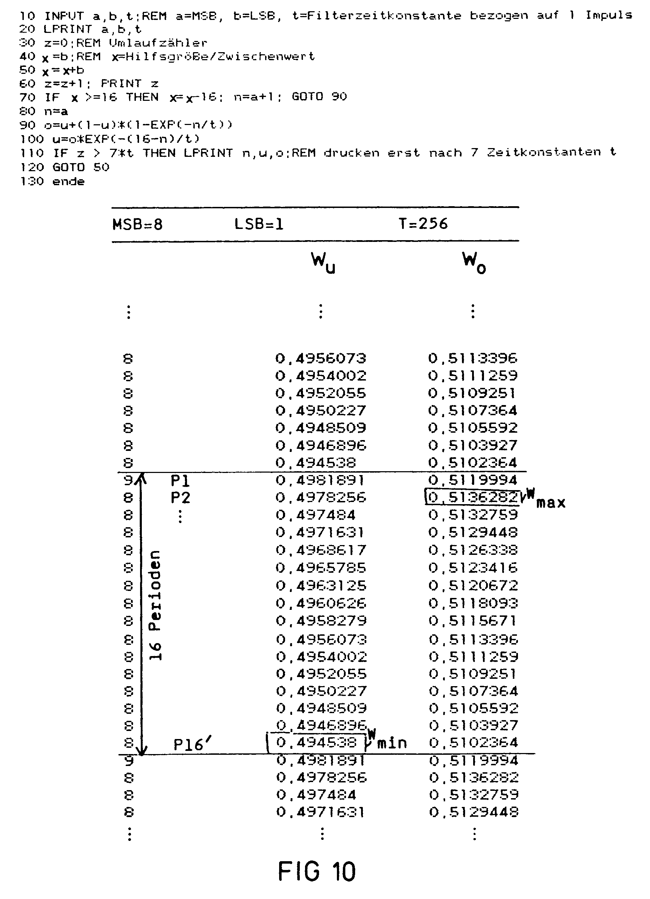

Um die Vorzüge des erfindungsgemäßen Verfahrens an einem weiteren Beispiel hinsichtlich der Restwelligkeit (Brummen) des Analogwertes AW in bezug auf seinen Mittelwert (vgl. Figur 7) zu verdeutlichen, wird auf die Figuren 9 und 10 Bezug genommen. Figur 9 zeigt das zeitliche Verhalten des Analogwertes AW zunächst während einer Einstellzeit $T_e$ und anschließend im eingeschwungenen Zustand. Der Kurvenverlauf ist aus Teilstücken ansteigender bzw. abfallender e-Funktionen (Filterstufe erster Ordnung) gebildet, wobei sich der Mittelwert des Analogwertes AW entlang einer e-Funktion dem gewünschten, umzusetzenden Wert nähert. In diesem Beispiel ist angenommen, daß der umzusetzende Digitalwert annähernd 50 % betägt, d. h. bei einer Auflösung von 4 Bit für den Hochwert MSB und 4 Bit für den Niederwert LSB (entsprechend 256 diskrete Werte) wird ein Wert 129 (entsprechend 50,39 %) gewählt, der aus Hochwert MSB = 8/16 und Niederwert LSB = 1/16 (vgl. Figur 1) zusammengesetzt wird. In diesem Fall werden 15 Perioden mit einer Einschaltimpulsdauer von 8 Systemtaktdauern und eine Periode mit einer Einschaltimpulsdauer von 9 Systemtaktdauern gebildet. Aufgrund der Anstiegs- bzw. Abfallcharakteristik der e-Funktion hat das Brummen im Bereich von 50 % des Analogwertes AW die größte Relevanz und wird daher zu Vergleichszwecken herangezogen.

Figur 10 zeigt für einen konstanten Mittelwert des Analogwertes AW jeweils die unteren $W_u$ und oberen Werte $W_o$ für den Analogwert AW, die für jede Periode nach einem oben in der Figur 10 gezeigten Rechenprogramm theoretisch ermittelt worden sind. In der Zahlenkolonne der Figur 10 ist ein Zyklus von 16 Perioden P1 bis P16' herausgegriffen, wobei in der ersten Spalte jeweils die Einschaltimpulsdauer in Vielfachen der Systemtaktdauer $t_o$ angegeben ist. Nach einer Periode P1 mit einer verlängerten Einschaltimpulsdauer (9 Systemtaktdauern) steigen die oberen Werte $W_o$ bzw. unteren Werte $W_u$ zunächst an, so daß sich ein größter oberer Wert $W_{max}$ (vgl. Figur 9) von 0,5136 und ein kleinster unterer Wert $W_{min}$ am Ende der Folge von 16 Perioden von 0,4945 ergibt. Die Differenz D zwischen den Werten $W_{max}$ und $W_{min}$ ist ein Maß für die verbleibende Restwelligkeit bzw. das sogenannte Brummen des Ausgangssignals und beträgt bei diesem Beispiel 0,019. Die Zeitkonstante T des Filters ist bei vorliegendem Beispiel mit der 256-fachen Systemtaktdauer $t_o$ angenommen.

Berechnet man die Verhältnisse für das bisher bekannte Verfahren mit dem in der Figur 11 gezeigten Rechnerprogramm für obiges Beispiel, ergibt sich bei gleicher Zeitkonstante T = 256 $t_o$ eine Abweichung zwischen größtem und kleinstem Wert von 0,245, d. h. eine wesentlich höhere Restwelligkeit. Zur Erzielung einer vergleichbar geringen Restwelligkeit wäre bei dem bekannten Verfahren die Zeitkonstante um das 16-fache auf einen Wert von T' = 4096 $t_o$ zu erhöhen, wobei die Grenzfrequenz des Systems in erheblicher Weise abnehmen würde.

## Patentansprüche

1. Digital-Analog-Umsetzverfahren, bei dem ein umzusetzender Digitalwert (DW) durch eine zeitliche Folge ($T_F$) von mehreren Perioden (P1...P16') mit jeweils einem durch das jeweilige Verhältnis von Einschaltimpulsdauer ($t_p$) zu Periodendauer ($T_p$) bestimmten Tastverhältnis dargestellt wird, wobei die Einschaltimpulsdauern ($t_{p1}...t_{p16}$) und die Periodendauer ($T_p$) Vielfache einer Systemtaktdauer ($t_o$) sind, bei dem eine Anzahl von Perioden (P3', P5',...P16') der Folge ($T_F$) eine Einschaltimpulsdauer ($t_{p3}$, $t_{p5}...t_{p16}$) aufweist, die sich von der jeweiligen Einschaltimpulsdauer der übrigen Perioden der Folge ($T_F$) um eine Systemtaktdauer ($t_o$) unterscheidet, wobei Perioden mit gleichen Einschaltimpulsdauern ($t_{p3}$, $t_{p5}...t_{p16}$) annähernd gleichmäßig in der Folge ($T_F$) verteilt werden, und bei dem die Tastverhältnisse der Perioden (P1...P16') zur Erzeugung eines Analogwertes (AW) ausgewertet werden.

2. Verfahren nach Anspruch 1,
**dadurch gekennzeichnet,** daß der Digitalwert (DW) aus einem Hochwert (MSB) und einem Niederwert (LSB) zusammengesetzt wird, wobei die Einschaltimpulsdauern ($t_{p1}...t_{p16}$) für jede Periode (P1...P16') zunächst dem Hochwert (MSB) entsprechend bemessen werden, daß ein Laufwert (LW) unter der Bedingung O≦ Laufwert (LW) < größtmöglicher Niederwert

(LSB$_{max}$) gewählt wird,

daß nachfolgend für jede Periode (P1...P16') der Folge die Summe von Niederwert (LSB) und Laufwert (LW) neu als Laufwert (LW) verwendet wird und

daß in dem Fall, daß der Laufwert (LW) größer oder gleich dem größtmöglichen Niederwert (LSM$_{max}$) ist,

- für die jeweilige Periode (P3') die entsprechend dem Hochwert (MSB) bemessene Einschaltimpulsdauer (t$_{p3}$) um eine Systemtaktdauer (t$_o$) verlängert wird und
- die Differenz zwischen Laufwert (LW) und größtmöglichem Niederwert (LSB$_{max}$) neu als Laufwert (LW) verwendet wird.

3. Verfahren nach Anspruch 1,
**dadurch gekennzeichnet,** daß der Digitalwert (DW) aus einem Hochwert (MSB) und einem Niederwert (LSB) zusammengesetzt wird, wobei die Einschaltimpulsdauern (t$_{p1}$...t$_{p16}$) jeder Periode (P1...P16') zunächst dem um eine Systemtaktdauer (t$_o$) erhöhten Hochwert (MSB) entsprechend bemessen werden,

daß ein Laufwert (LW) unter der Bedingung
O$\leq$ Laufwert (LW) < größtmöglicher Niederwert (LSB$_{max}$) gewählt wird,

daß nachfolgend für jede Periode (P1...P16') der Folge die Summe von Niederwert (LSB) und Laufwert (LW) neu als Laufwert (LW) verwendet wird,

daß in dem Fall, daß der Laufwert (LW) kleiner als der größtmögliche Niederwert (LSB$_{max}$) ist, der Hochwert (MSB) um eine Systemtaktdauer (t$_o$) erniedrigt wird und

daß in dem Fall, daß der Laufwert (LW) größer oder

gleich dem größtmöglichen Niederwert (LSB$_{max}$) ist,
die Differenz zwischen Laufwert (LW) und größtmöglichem Niederwert (LSB$_{max}$) neu als Laufwert (LW) verwendet wird.

4. Vorrichtung zur Durchführung des Verfahrens nach Anspruch 2, mit
- einem ersten Addierer (21), dessen einer Eingang (20) mit einem dem Niederwert (LSB) entsprechenden Wert beaufschlagbar ist, dessen weiterer Eingang (26) mit einem Ausgang eines Speichers (24) verbunden ist, der seinerseits eingangsseitig (23) mit einem Ausgang (25) des ersten Addierers (21) verbunden ist,
- einem zweiten Addierer (30), dessen einer Eingang (31) mit einem dem Hochwert (MSB) entsprechenden Wert beaufschlagbar ist und dessen weiterer Eingang (32) mit einem Überlaufausgang (27) des ersten Addierers (21) verbunden ist,
- mit einem systemtaktgesteuerten Zähler (46), dessen Überlaufausgang (48) mit einem Übernahmeeingang (28) des ersten Speichers (24) verbunden ist,
- einem Vergleicher (41), dessen einer Eingang (42) mit dem Ausgang (45) des Zählers (46) und dessen weiterer Eingang (40) mit dem Ausgang (34) des zweiten Addierers (30) verbunden ist und der ausgangsseitig einen Schalter (51) steuert, und
- einer Referenzgrößenquelle, die bei geschlossenem Schalter (51) eine Filterstufe (60) beaufschlagt, an der ausgangsseitig ein Analogwert (AW) abgreifbar ist.

5. Vorrichtung zur Durchführung des Verfahrens nach Anspruch 3, mit
- einem ersten Addierer (21), dessen einer Eingang (20) mit einem dem Niederwert (LSB) entsprechenden Wert beaufschlagbar ist, dessen weiterer Eingang (26) mit einem Ausgang eines Speichers (24) verbunden ist, der seinerseits eingangsseitig (23) mit einem Ausgang (25) des ersten Addierers (21) verbunden ist,
- einem zweiten Addierer (30) mit einem Eingang (31), der mit einem dem Hochwert (MSB) entsprechenden Wert beaufschlagbar ist, mit einem weiteren Eingang (33), der mit einer der Systemtaktdauer (t$_o$) entsprechenden Wert beaufschlagbar ist und mit einem Subtraktionseingang (32'), der über einen Inverter mit einem Überlaufeingang (27) des ersten Addierers verbunden ist,
- mit einem systemtaktgesteuerten Zähler (46), dessen Überlaufausgang (48) mit einem Übernahmeeingang (28) des ersten Speichers (24) verbunden ist,
- einem Vergleicher (41), dessen einer Eingang (42) mit dem Ausgang (45) des Zählers (46) und dessen weiterer Eingang (40) mit dem Ausgang (34) des zweiten Addierers (30) verbunden ist und der ausgangsseitig einen Schalter (51) steuert, und
- einer Referenzgroßenquelle, die bei geschlossenem Schalter (51) eine Filterstufe (60) beaufschlagt, an der ausgangssei tig ein Analogwert (AW) abgreifbar ist.

MSB        LSB

| 10/16 | 7/16 | — DW |

$10 \cdot 6,25\,\%$    $7 \cdot 0,39\,\%$

$62,5\,\%$     $2,73\,\%$

$65,23\,\%$

## FIG 1

$LSB_{max} = 16$
$LW = 0$
$LSB = 7$

$LW + LSB \Rightarrow LW$ —10

## FIG 4

N    $LW \geq LSB_{max}$ —11

J

12 — C1=0

$LW - LSB_{max} \Rightarrow LW$ —13

C1=1

26

21   25

28

24

LSB

20    27

23

C1

## FIG 6

EP 0 501 598 A2

P1   P2   P3′   P4   P5′   ···   P10′   P11   P12′   P13   P14′   P15   P16′

I1                                                                        I16

$t_{p1}$  $t_{p2}$  $t_{p3}$  $t_{p4}$  $t_{p5}$          $t_{p12}$

$T_p$

$T_F$

## FIG 2

P1                          P2                          P3′

$t_{p1} = 10 \cdot t_o$     $t_{p2} = 10 \cdot t_o$     $t_{p3} = 11 \cdot t_o$

$T_p = 16 \cdot t_o$        $T_p$                       $T_p$

CLK
···

$t_o$                                                   t

## FIG 3

EP 0 501 598 A2

FIG 7

FIG 9

10

| DL | LW | | C1 | |
|----|----|-----|----|-----|
|    |    | 0   | -  |     |
| 1  |    | 7   | 0  | P1  |
| 2  |    | 14  | 0  | P2  |
| 3  | (21) | 5 | 1  | P3′ |
| 4  |    | 12  | 0  | ⋮   |
| 5  | (19) | 3 | 1  |     |
| 6  |    | 10  | 0  |     |
| 7  | (17) | 1 | 1  |     |
| 8  |    | 8   | 0  |     |
| 9  |    | 15  | 0  |     |
| 10 | (22) | 6 | 1  |     |
| 11 |    | 13  | 0  |     |
| 12 | (20) | 4 | 1  |     |
| 13 |    | 11  | 0  |     |
| 14 | (18) | 2 | 1  |     |
| 15 |    | 9   | 0  |     |
| 16 | (16) | 0 | 1  | P16′ |
| 17 |    | 7   | 0  |     |
| ⋮  |    | ⋮   | ⋮  |     |

FIG 5

```
10      input a, t :rem a = 8Bit, t = Filterzeitkonstante bez. auf 1 Im
20      lprint a,t
30      u=0
40      z=0 :rem Umlaufzähler
50      z=z+1 : print z
60      n=a
70      o=u+(1-u)*(1-exp(-n/t)): rem O = oberer Wert, u = unterer Wert
80      u=o*exp(-(256-n)/t)
90      if z > 7*t then lprint n,u,o:goto 110:rem drucken nach 7*t
100     goto 50
110     end
```

$T = 256 \cdot t_0$ ; $n = 129$

$W_{Min} \triangleq u = 0.381296$  $W_{Max} \triangleq o = 0.6262$  $D = 0,2449$

$T' = 4096 \cdot t_0$ ; $n = 129$

$W_{Min} \triangleq u = 0.496093$  $W_{Max} \triangleq o = 0.511716$  $D = 0,015623$

FIG 11

LSB=0111    MSB=1010    LW=0

| CLK | 24 | 27 | 48 | 45 | 34 | 42 | | |
|---|---|---|---|---|---|---|---|---|
| 1 | 0111 | 0 | 0 | 0000 | 1010 | 1 | | |
| 2 | | | 0 | 0001 | . | 1 | | |
| 3 | | | . | 0010 | . | 1 | | |
| 4 | | | . | 0011 | . | 1 | | |
| 5 | | | . | | | 1 | | |
| 6 | | | | . | | 1 | 10 | P1 |
| 7 | | | | . | | 1 | | |
| 8 | | | | . | | 1 | | |
| 9 | | | | 1000 | | 1 | | |
| 10 | | | | 1001 | | 1 | | |
| 11 | | | | 1010 | | 0 | | |
| 12 | | | | 1011 | | 0 | | |
| 13 | | | | | | | | |
| 14 | | | | . | | | | |
| 15 | | | | | | | | |
| 16 | | | 0 | 1111 | 1010 | 0 | | |
| 17 | 1110 | 0 | 1 | 0000 | . | | | |
| 18 | | | 0 | . | . | | | |
| 19 | | | . | . | . | | | |
| 20 | | | | | | | | |
| ⋮ | | | | | | | | |
| 25 | | | | | | | | P2 |
| ⋮ | | | | | | | | |
| 30 | | | | | | | | |
| 32 | | | | | | | | |
| 33 | 0101 | 1 | 1 | 0000 | 1011 | 1 | | |
| | | | | 0001 | | 1 | | |
| 35 | | | | 0010 | | 1 | | |
| | | | | 0011 | | 1 | | |
| ⋮ | | | | 0100 | . | 1 | | |
| | | | | 0101 | . | 1 | 11 | |
| | | | | 0110 | | 1 | | |
| 40 | | | | 0111 | | 1 | | P3' |
| | | | | 1000 | | 1 | | |
| ⋮ | | | | 1001 | | 1 | | |
| | | | | 1010 · | 1011 | 1 | | |
| | | | | 1011 | 1011 | 0 | | |
| 45 | | | | 1100 | 1011 | 0 | | |
| | | | | 1101 | . | 0 | | |
| ⋮ | | | | 1110 | . | 0 | | |
| 48 | | | | 1111 | 1011 | 0 | | |
| 49 | 1100 | 0 | 1 | 0000 | 1010 | 1 | | |
| 50 | | | | . | . | . | | P4 |

FIG 8

```
10 INPUT a,b,t:REM a=MSB, b=LSB, t=Filterzeitkonstante bezogen auf 1 Impuls
20 LPRINT a,b,t
30 z=0:REM Umlaufzähler
40 x=b:REM x=Hilfsgröße/Zwischenwert
50 x=x+b
60 z=z+1: PRINT z
70 IF x >=16 THEN x=x-16: n=a+1: GOTO 90
80 n=a
90 o=u+(1-u)*(1-EXP(-n/t))
100 u=o*EXP(-(16-n)/t)
110 IF z > 7*t THEN LPRINT n,u,o:REM drucken erst nach 7 Zeitkonstanten t
120 GOTO 50
130 ende
```

| MSB=8 | | LSB=1 | T=256 |
|---|---|---|---|
| | | $W_u$ | $W_o$ |
| | | ⋮ | ⋮ |
| 8 | | 0,4956073 | 0,5113396 |
| 8 | | 0,4954002 | 0,5111259 |
| 8 | | 0,4952055 | 0,5109251 |
| 8 | | 0,4950227 | 0,5107364 |
| 8 | | 0,4948509 | 0,5105592 |
| 8 | | 0,4946896 | 0,5103927 |
| 8 | | 0,494538 | 0,5102364 |
| 9 | P1 | 0,4981891 | 0,5119994 |
| 8 | P2 | 0,4978256 | 0,5136282 $W_{max}$ |
| 8 | ⋮ | 0,497484 | 0,5132759 |
| 8 | | 0,4971631 | 0,5129448 |
| 8 | | 0,4968617 | 0,5126338 |
| 8 | | 0,4965785 | 0,5123416 |
| 8 | | 0,4963125 | 0,5120672 |
| 8 | | 0,4960626 | 0,5118093 |
| 8 | | 0,4958279 | 0,5115671 |
| 8 | | 0,4956073 | 0,5113396 |
| 8 | | 0,4954002 | 0,5111259 |
| 8 | | 0,4952055 | 0,5109251 |
| 8 | | 0,4950227 | 0,5107364 |
| 8 | | 0,4948509 | 0,5105592 |
| 8 | | 0,4946896 | 0,5103927 |
| 8 | P16' | 0,494538 $W_{min}$ | 0,5102364 |
| 9 | | 0,4981891 | 0,5119994 |
| 8 | | 0,4978256 | 0,5136282 |
| 8 | | 0,497484 | 0,5132759 |
| 8 | | 0,4971631 | 0,5129448 |
| ⋮ | | ⋮ | ⋮ |

(16 Perioden)

FIG 10